# EUROPÄISCHE PATENTANMELDUNG

(11) **EP 1 100 152 A2**
(43) Veröffentlichungstag der Anmeldung: **16.05.2001**
(21) Anmeldenummer: 00123829.4
(22) Anmeldetag: 02.11.2000
(51) Int. Cl.: H01R 12/08, H01R 9/24, H01R 13/66, H01R 25/00

(54) **Verteiler und Verteilersystem**

(30) Priorität: 13.11.1999 DE 29919901 U; 13.11.1999 DE 29919900 U
(71) Anmelder: Weidmüller Interface GmbH & Co., 32760 Detmold (DE)
(72) Erfinder: Reker, Stefan, 33659 Bielefeld (DE)
(74) Vertreter: Specht, Peter, Dipl.-Phys.

(57) **Zusammenfassung**

Ein Verteiler zum Verbinden von Aktoren und/oder Sensoren mit einer Steuerungseinheit - Master, wobei der Verteiler Anschlüsse für die Aktoren und/oder Sensoren sowie eine Elektronik für die Versorgung der Aktoren und/oder Sensoren und die Weiterleitung der Aktoren-Sensoren-Signale zwischen der Steuerungseinheit und dem Verteiler aufweist, zeichnet sich dadurch aus, daß wenigstens einer der Anschlüsse (2) des Verteilers als Multifunktionsschnittstelle ausgelegt ist. Zur Ausbildung verschiedener Verteilervarianten sind ferner baulich identische Elektronikbauteile (8) mit unterschiedlich ausgelegten Anschlußbauteilen (1) kombinierbar.

## Beschreibung

Die Erfindung betrifft einen Verteiler nach dem Oberbegriff des Anspruches 1 und ein zugehöriges Verteilersystem nach dem Oberbegriff des Anspruches 6.

Verteiler für ein Verteilersystem nach Art des Oberbegriffes des Anspruches 1 sind aus der DE G 2 99 05025.4 bekannt. Die in dieser Schrift dargestellten Verteiler verbessern Verteiler nach Art der EP 0 695 468 B1. Ein typischer Einsatzbereich derartiger Verteiler ist die Verbindung der Aktoren und/oder Sensoren mit einem Bussystem, insbesondere mit entsprechenden Formleitungskabeln. Der Verteiler weist Anschlüsse für die Aktoren und/oder Sensoren sowie eine Elektronik für die Versorgung der Aktoren und/oder Sensoren und die Weiterleitung der Aktoren-Sensoren-Signale zum Master auf. Der Verteiler ist besonders servicefreundlich, da er ein erstes Bauteil mit den Anschlüssen zum Verbinden der Aktoren und/oder Sensoren sowie ein zweites, gesondertes Bauteil mit der Elektronik aufweist und die Bauteile mechanisch und elektrisch lösbar miteinander verbindbar sind. Dank dieser Ausgestaltung kann im Fall eines Schadens an der Elektronik das Elektronikbauteil als reines Serviceteil problemlos ausgewechselt werden, während das erste Bauteil mit der passiven Verkabelung der eigentlichen Sensor-Aktor-Installation erhalten bleibt und damit auch die passive Verkabelung stehen bleibt. Dank der Bauweise des Verteilers könnten auch die ihn bildenden Bauteile jeweils für sich genommen problemlos in einer hohen Schutzart, insbesondere in einer Schutzart größer als IP 65, beispielsweise IP 67, ausgeführt werden.

Die Verteiler der vorstehend angegebenen Bauart sind beispielsweise mit einer ASI-Elektronik (AKUTATOR SENSOR INTERFACE) versehbar. Das ASI-Interface ist ein Interface für die Automatisierung, insbesondere für einfache Elemente im Maschinen- oder Anlagenbau. Eine einfache 2-Drahtleitung ermöglicht den Anschluß von bis zu 31 Teilnehmern (Slaves) an einen Master (z.B. Microcontroller) bzw. den Anschluß an max. 124 Sensoren oder Aktoren.

Eine der Neuerungen auf dem Gebiet der ASI-Elektronik ist die Einführung der A²SI-Ics der Firma AMI (American Microsystems Inc.). Elektronikbausteine dieser Art ermöglichen bei Nutzung als SLAVE-Schnittstellen-IC über einen "zusätzlichen Adressierungskanal" den Anschluß von bis zu 62 SLAVE-Einheiten über 3*100 m an einen MASTER. Damit können doppelt so viel SLAVE-Einheiten an den neuen ASI-Baustein angeschlossen werden wie bei bisherigen ASI-Lösungen. Der neue ASI-Baustein ist zu bisherigen ASI-Lösungen kompatibel.

Das ASI-Bussystem überträgt Befehle in Form einer standardisierten Sequenz mit Adress- und Informationsbits, wobei die neueren A²Si-Ics zur Erhöhung der Anzahl adressierbarer Teilnehmer/Verteiler wenigstens ein Informationsbit als Adressbit nutzen (genauer betrachtet das I3-Bit). Hierdurch reduziert sich die Anzahl der an den Verteiler anschließbaren Sensoren/Aktoren um wenigstens eins. In Hinsicht auf die eingangs beschriebenen Verteiler hat die A²SI-IC-Technik z.B. die Konsequenz, daß aus 4E/4A-Anschlußverteilersystemen jeweils 4E/33A-Anschlußverteilersysteme werden. Einer der Anschlüsse eines konventionellen 4E/4A-Verteilers mit acht Anschlußbuchsen ist damit überzählig, er könnte eigentlich eingespart werden.

Die Erfindung setzt bei der Aufgabe an, diesen Anschluß am Verteiler einer vorteilhaften Nutzung zuzuführen.

Dabei wird der durch die Reduzierung der Anzahl der Informationsbits freie Anschluß am Verteiler derart mit der Elektronik verbunden, daß er als Mulitfunktionsanschluß oder - allgemeiner - als Multifunktionsschnittstelle nutzbar ist. Der Anschluß könnte zwar eigentlich auch ganz eingespart werden. Dies würde aber bedeuten, die relativ teuren Werkzeuge zur Herstellung der Verteiler für die A²SIC-Lösungen umgestalten zu müssen. Dies vermeidet die Erfindung.

Je nach Wunsch ist es beispielsweise möglich, die Multifunktionsbuchse derart mit der Elektronik und/oder den weiteren Anschlüssen zu verbinden, daß sie als Diagnoseschnittstelle nutzbar ist. Alternativ ist es z.B. möglich, die Multifunktionsbuchse derart mit der Elektronik und/oder den weiteren Anschlüssen zu verbinden, daß sie zur Realisierung einer T-Stückverbindung einsetzbar ist.

Die Erfindung eignet sich nach einer ihrer Varianten insbesondere auch für Verteiler, die derart beschaffen sind, daß bei verschiedenen Verteilervarianten, deren Anzahl an Ein- und Ausgängen eine konstante Gesamtsumme bildet, identische Elektronikbauteile und unterschiedlich ausgelegte Anschlußbauteile mit unterschiedlichen Anschlußbauteil-Leiterbahnführungen und/oder Anschlußbauteil-Verdrahtun-gen kombinierbar ist.

Die Erfindung schafft mit den aus der DE G 299 050 25.4 bekannten Verteilern sowie mit den Verteilern nach einem der Ansprüche 1 bis 5 ferner auf einfache Weise ein Verteilersystem mit verschiedenen Verteilervarianten. Die Erfindung erreicht dies durch den Gegenstand des Anspruches 6. Danach werden zur Ausbildung verschiedener Verteilervarianten baulich identische Elektronikbauteile mit unterschiedlich ausgelegten Anschlußbauteilen kombiniert. Besonders bevorzugt sind mit den baulich identischen Elektronikbauteilen und den unterschiedlich ausgelegten Anschlußbauteilen Verteilervarianten realisierbar, deren Anzahl an Ein- und Ausgängen eine konstante Gesamtsumme bildet. Der besondere Vorteil dieser Lösung liegt darin, daß nur eine einzige Elektronik für verschiedene Verteilervarianten benötigt wird. Die Anpassung an die jeweilige Verteileraufgabe (z. B. Anschluß antivalenter Sensoren oder z.B. zwei Sensoren/Aktoren mit nachgeschaltetem T-Stück oder z.B. ,,DESINA"-konforme Aktoren mit Rückmelder) erfolgt allein durch Variation der Anschlußbauteil-Leiterbahnführungen und/oder der Anschlußbauteil-Verdrahtungen. Diese Variation ist durchführbar, ohne daß eine zusätzliche Anpassung der Elektronik an die unterschiedlichen Einsatzzwecke notwendig wäre.

Ausführungsbeispiele werden nachstehend unter Bezugnahme auf die Zeichnung näher beschrieben. Es zeigt:
- Figur 1: einen Verteiler gemäß der Erfindung in sprengbildlicher Darstellung,
- Figur 2: einen montierten Verteiler gemäß der Erfindung im Längsschnitt,
- Figur 3: eine Einzelheit des Verteilers nach Figur 2,
- Figur 4: eine Einzelheit entsprechend Figur 2 bei einem weiteren Verteiler gemäß der Erfindung, und
- Figur 5: ein Prinzipschaltbild, welches die Nutzung einer der Anschlußbuchsen des Verteilers als Multifunktionsschnittstelle veranschaulicht.

Der Verteiler setzt sich aus mehreren Bauteilen zusammen. Er beinhaltet ein erstes Bauteil 1 mit der eigentlichen Aktor-Sensor-Installation und deren passiver Verkabelung. In dem ersten Bauteil 1 sind diverse Anschlüsse 2 in Form von Buchsen vorgesehen, in die die Stecker der zu den Aktoren und/oder Sensoren führenden Kabel eingesteckt werden können. In dem ersten Bauteil 1 stehen die Anschlüsse 2 in elektrisch leitender Verbindung mit einer Leiterplatte 3, deren Leiterbahnen zu einer Gruppe von Kontaktstiften 4 führen. Die Leiterplatte 3 im ersten, passiven Bauteil 1 ist im übrigen nur mit einigen Leuchtdioden und Widerständen bestückt.

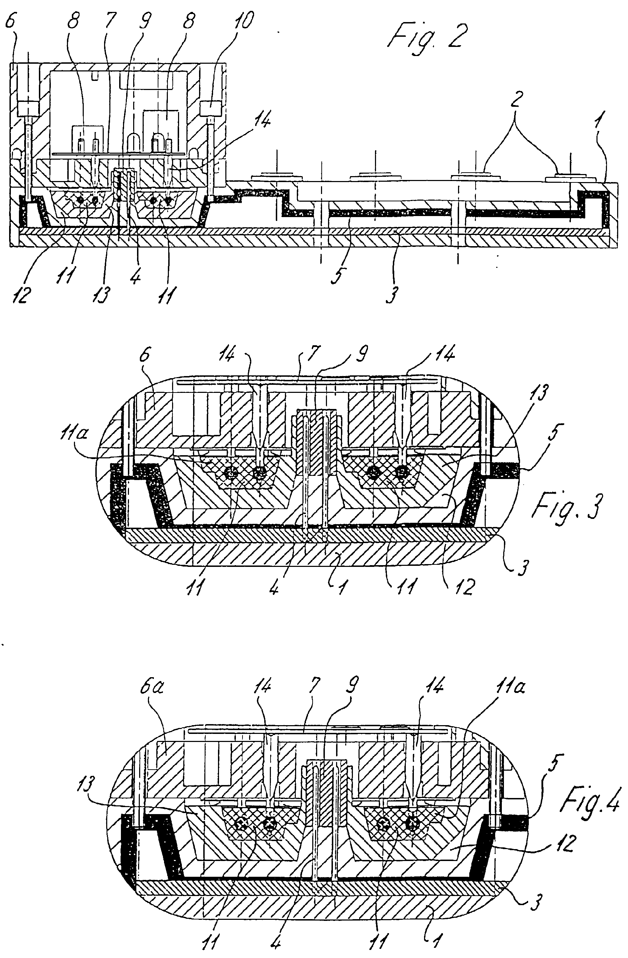

Das Bauteil 1 ist in der Schutzart IP 67 ausgeführt. Ein dementsprechender Verlauf einer Vergußmasse 5 ist in Figur 2 illustriert.

Der Verteiler beinhaltet in seinem grundsätzlichen Aufbau ein zweites, gesondertes Bauteil 6, das die Elektronik für die Versorgung der Aktoren und/oder Sensoren und die Weiterleitung der Aktoren-Sensoren-Signale beinhaltet. Dieses zweite Elektronikbauteil 6 ist elektrisch und mechanisch lösbar und damit auswechselbar mit dem ersten passiven Bauteil 1 verbunden. Im dem Elektronikbauteil 6 befindet sich eine Leiterplatte 7, die je nach dem entsprechenden Anwendungsfall mit entsprechenden Elektronikbauelementen 8 bestückt ist und ferner mit einer der Kontaktstiftgruppe 4 des passiven Bauteiles 1 entsprechend konfigurierten Buchse 9 .bestückt ist, so daß bei der Montage der beiden Bauteile über die Kontaktstifte 4 und die Buchse 9 ihre elektrische Verbindung durch Steckung hergestellt wird. Zur mechanischen Verbindung sind Befestigungsschrauben 10 vorgesehen, mit denen das Elektronikbauteil 6 auf dem ersten passiven Bauteil 1 festgeschraubt werden kann.

Dank dieses grundsätzlichen Aufbaus ist das Elektronikbauteil 6 ein reines Serviceteil, das im Fall des Schadens an der Elektronik problemlos ausgewechselt werden kann. Die passive Verkabelung im Bauteil 1 bleibt dabei stehen.

Unter Beibehaltung des vorstehend geschilderten Aufbauprinzipes für einen derartigen Verteiler können mehrere Elektronikbauteile vorgesehen werden, die bezüglich der Weiterleitungsfunktion der Elektronik unterschiedlich gestaltet sind. Es kann sich dabei um Kabelanschlüsse aller Art aber auch Steckanschlüsse für weitere Module oder dergleichen handeln. Nach der Idee der Erfindung ist es aber insbesondere auch möglich, ausgehend von einer festen Elektronik durch Variation der Leiterbahnführung / Verdrahtung des Anschlußbausteins verschiedene Verteilervarianten zu realisieren.

Es versteht sich, daß auch die auswechselbaren Elektronikbauteile in der entsprechenden Schutzart, beispielsweise IP 67, auszuführen sind. Im übrigen wird auch eine entsprechend dichte Steckverbindungsart bei den Anschlüssen 2 für die Kabel zu den Aktoren und/oder Sensoren vorgesehen.

Ein typisches Anwendungsgebiet für derartige Verteiler ist die Verbindung der Aktoren und/oder Sensoren mit einem Bussystem, insbesondere die Verbindung mit Formleitungskabeln. Die in den Zeichnungen dargestellten Ausführungsformen beziehen sich auf eine solche Ausführung.

Im dargestellten Ausführungsbeispiel ist für diesen Anwendungsfall in dem ersten passiven Bauteil 1 eine bezüglich der Formleitungskabel 11 querschnittsneutrale Aufnahme 12 vorgesehen. In diese kann ein im Ausführungsbeispiel bezüglich zweier Formleitungskabel 11 querschnittsadaptiertes Kabelkanalstück 13 eingesetzt werden, das dann die beiden Formleitungskabel 11 in einer vorgegebenen Raumlage aufnimmt. Bei einem derartigen Anwendungsfall ist die Leiterplatte 7 des Elektronikbauteiles 6 mit einer Anzahl von Kontaktstiften 14 bestückt, die in einer dem Einsatzzweck entsprechenden Anzahl und Raumlage vorgesehen sind und die bei der Montage des Bauteiles 1 und des Bauteiles 6 funktionsgerecht die entsprechenden Leiter in den Formleitungskabeln 11 isolationsdurchdringend kontaktieren.

Das Kabelkanalstück 13 hat eine Durchtrittsöffnung für die Kontaktstifte 4 und die Buchse 9.

Das Kabelkanalstück 13 kann um 180° versetzt in der querschnittsneutralen Aufnahme 12 des Bauteiles 1 eingesetzt werden, so daß die Formleitungskabel 11 dem Verteiler in unterschiedlicher Richtung zugeführt werden können. Bei dieser Ausgestaltung eines Kabelkanalstückes für sämtliche vorgesehene Formleitungskabel führt die Umsetzung um 180° zu einer Polatitätsvertauschung bezüglich der Lage der Formleitungskabel 11 im Kabelkanalstück 13. Dies ergibt sich aus einem Vergleich der Figuren 3 und 4 aus der jeweils unterschiedlichen Lage der kleinen seitlichen Formelemente 11a an den Formleitungskabeln 11. Bei dem bausatzartig ausgelegten Verteiler sind von daher Elektronikbauteile entsprechend unterschiedlicher Polarität vorgesehen. Die Figur 6 zeigt in entsprechendem Teilausschnitt ein Elektronikbauteil 6a mit im Verhältnis zum Elektronikbauteil 6 nach Figur 3 inverser Polarität.

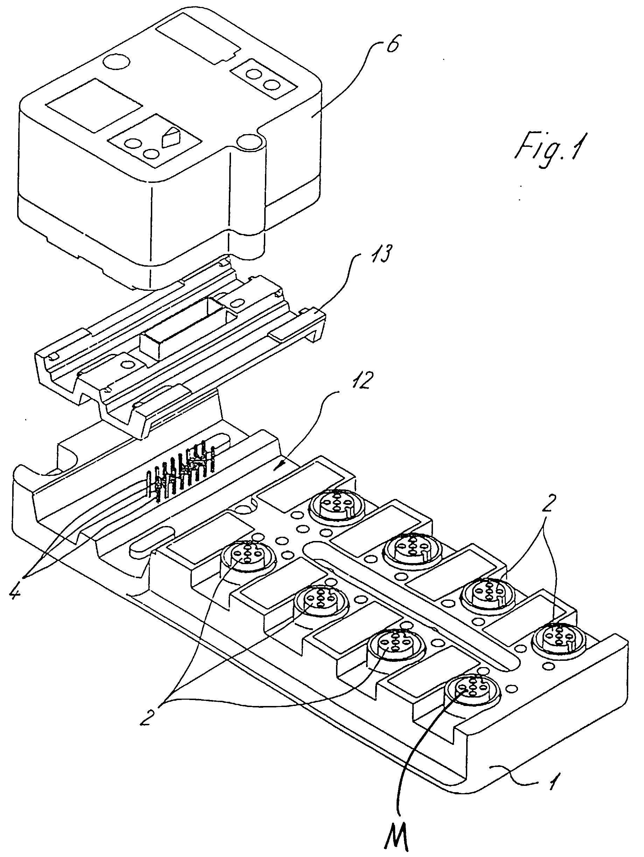

Der Verteiler der Fig. 1 weist ferner einen Anschluß M in Form einer Buchse auf, der wie die Anschlüsse 2 in elektrisch leitender Verbindung mit einer Leiterplatte 3 stehen kann. Die Buchse M wird als Funktionsschnittstelle z.B. für Diagnosezwecke genutzt.

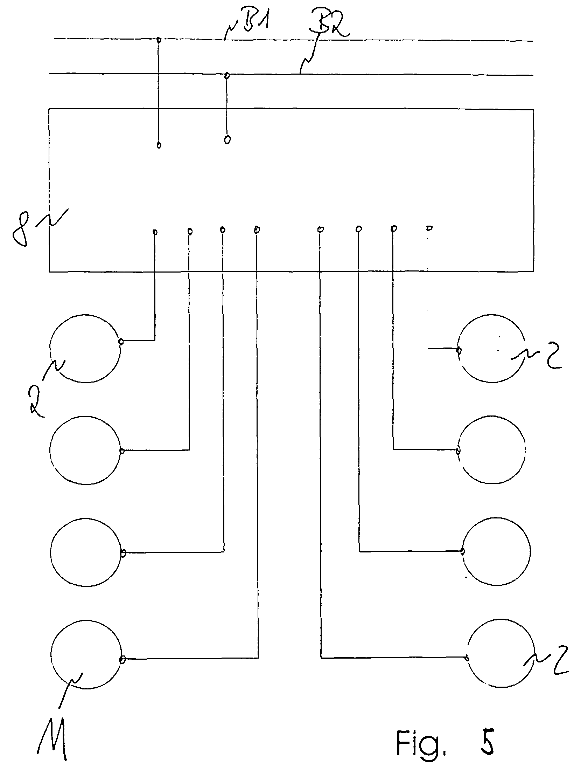

Figur 5 zeigt ein vereinfachtes Prinzipschaltbild eines Verteilers für den A²SI-IC. Dieser Verteiler weist wiederum Anschlüsse 2 für die Aktoren und/oder Sensoren sowie die Elektronik 8 für die Versorgung der Aktoren und/oder Sensoren und die Weiterleitung der Aktoren-Sensoren-Signale zwischen der Steuerungseinheit und dem Verteiler über den Bus B1, B2 (siehe die Formleitungskabel 11 der Fig. 2) auf, wobei das Bussystem Befehle in Form einer standardisierten Sequenz mit Adress-und Informationsbits überträgt, und wobei zur Erhöhung der Anzahl adressierbarer Teilnehmer/Verteiler wenigstens ein Informationsbit als Adressbit genutzt ist, so daß die Anzahl der an den Verteiler anschließbaren Sensoren/Aktoren um wenigstens eins reduziert ist.

Dabei ist der durch die Reduzierung der Anzahl an Informationsbits freie Anschluß am Verteiler derart mit der Elektronik 8 verbunden, daß er als Multifunktionsanschluß M nutzbar ist.

## Patentansprüche

1. Verteiler zum Verbinden von Aktoren und/oder Sensoren mit einer Steuerungseinheit - Master, wobei der Verteiler Anschlüsse für die Aktoren und/oder Sensoren sowie eine Elektronik für die Versorgung der Aktoren und/oder Sensoren und die Weiterleitung der Aktoren-Sensoren-Signale zwischen der Steuerungseinheit und dem Verteiler aufweist, **dadurch gekennzeichnet,** daß wenigstens einer der Anschlüsse (2) des Verteilers als Multifunktionsschnittstelle ausgelegt ist.

2. Verteiler nach Anspruch 1, dadurch gekennzeichnet, daß der als Multifunktionsanschluß genutzte Anschluß (2) am Verteiler als Diagnoseschnittstelle nutzbar ist.

3. Verteiler nach Anspruch 1 oder 2, dadurch gekennzeichnet, daß der als Multifunktionsanschluß genutzte Anschluß (2) am Verteiler derart mit der Elektronik und/oder den weiteren Anschlüssen verbunden ist, daß sie zur Realisierung einer T-Stückverbindung einsetzbar ist.

4. Verteiler nach einem der vorstehenden Ansprüche, dadurch gekennzeichnet, daß bei verschiedenen Verteilervarianten, deren Anzahl an Ein- und Ausgängen eine konstante Gesamtsumme bildet, identische Elektronikbauteile und unterschiedlich ausgelegte Anschlußbauteile mit unterschiedlichen Anschluß-Leiterbahnführungen und/oder Anschlußbauteilverdrahtungen kombinierbar sind.

5. Verteiler nach einem der vorstehenden Ansprüche, dadurch gekennzeichnet, daß für verschiedene Bussysteme jeweils ein einziges Elektronikbauteil vorgesehen ist.

6. Verteilersystem mit Verteilern, insbesondere mit Verteilern nach einem der vorstehenden Ansprüche, zum Verbinden von Aktoren und/oder Sensoren, mit Anschlüssen (2) für die Aktoren und/oder Sensoren sowie einer Elektronik (8) für die Versorgung der Aktoren und/oder Sensoren und die Weiterleitung der Aktoren-Sensoren-Signale, wobei die Verteiler jeweils ein erstes Bauteil (1) mit den Anschlüssen (2) zum Verbinden der Aktoren und/oder Sensoren und ein zweites gesondertes Bauteil (6) mit der Elektronik (8) aufweisen und die Bauteile (1 und 6) mechanisch und elektrisch lösbar miteinander verbindbar sind, dadurch gekennzeichnet, daß zur Ausbildung verschiedener Verteilervarianten baulich identische Elektronikbauteile (8) mit unterschiedlich ausgelegten Anschlußbauteilen (1) kombinierbar sind.

7. Verteilersystem nach Anspruch 6, dadurch gekennzeichnet, daß mit den baulich identischen Elektronikbauteilen (8) und den unterschiedlich ausgelegten Anschlußbauteilen (1) Verteilervarianten realisierbar sind, deren Anzahl an Ein-und Ausgängen eine konstante Gesamtsumme bildet.

8. Verteilersystem nach Anspruch 6 oder 7, dadurch gekennzeichnet, daß die verschiedenen Verteilervarianten mit baulich identischen Elektronikbauteilen (8) jeweils unterschiedliche Anschluβbauteil-Leiterbahnführungen und/oder Anschlußbauteil-Verdrahtungen aufweisen.

9. Verteilersystem nach einem der Ansprüche 6 bis 8, dadurch gekennzeichnet, daß für verschiedene Arten von Bussystemen jeweils ein einziges, an das jeweilige Bussysteme angepaßte Elektronikbauteil vorgesehen ist.
